# EUROPEAN PATENT APPLICATION

(11) **EP 2 145 910 A1**
(43) Date of publication of application: **20.01.2010**
(21) Application number: 08764295.5
(22) Date of filing: 08.05.2008
(51) Int. Cl.: C08G 73/10, C09J 179/08, H05K 1/03

(54) **LINEAR POLYIMIDE PRECURSOR HAVING ASYMMETRIC STRUCTURE, POLYIMIDE, AND THEIR PRODUCTION METHODS**

(30) Priority: 09.05.2007 JP 2007124882; 19.09.2007 JP 2007241767
(71) Applicant: JFE Chemical Corporation, Tokyo 111-0051 (JP)
(72) Inventor: HASEGAWA, Masatoshi, Funabashi-shi Chiba 274-8510 (JP); KITAMURA, Naoyuki, Tokyo 111-0051 (JP)
(74) Representative: Grünecker, Kinkeldey, Stockmair & Schwanhäusser Anwaltssozietät
(86) International application number: PCT/JP2008/058891
(87) International publication number: WO 2008/140107

(57) **Abstract**

A linear polyimide precursor includes a repeating unit represented by at least one formula selected from the group consisting of General Formula (1) and General Formula (2), the linear polyimide precursor having an intrinsic viscosity of 0.5 dL/g or more. 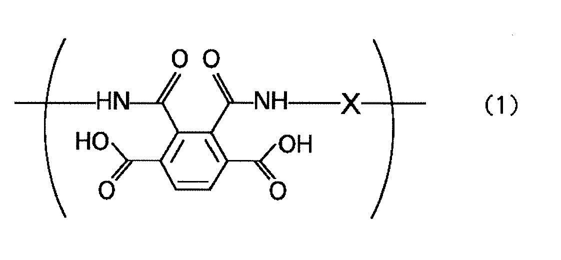 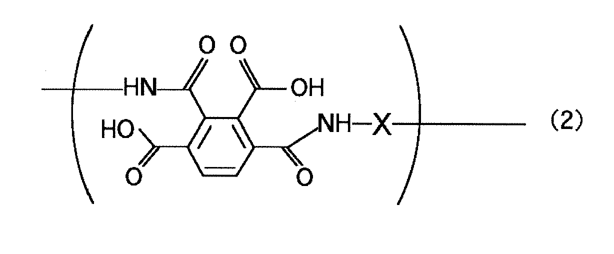 In General Formulas (1) and (2), X is a divalent aromatic group or a divalent aliphatic group excluding residues of 1,4-bis(4-aminophenoxy)benzene and bis(4-amino-3-methylphenyl)methane. The linear polyimide precursor has good solubility and thermoplasticity together with high glass transition temperature and toughness. Therefore, it is suitably used as a raw material of an asymmetric polyimide that is useful, for example, as a resin used for a flexible printed circuit (FPC) adhesive.

## Description

### Technical Field

The present invention relates to a polyimide having solubility and thermoplasticity better than before and also having high glass transition temperature and high toughness, a precursor of the polyimide, and a method for manufacturing them. Furthermore, the present invention relates to a heat-resistant adhesive, a copper clad laminate (CCL), and a flexible printed circuit (FPC) that use the polyimide.

### Background Art

Polyimides have characteristics such as good heat resistance, chemical resistance, radiation resistance, electric insulation, and good mechanical properties. Thus, polyimides are currently used in various electronic devices including an FPC substrate, a tape automated bonding (TAB) substrate, a protection film of a semiconductor device, and an interlayer insulating film of an integrated circuit. In recent years, polyimides have been increasingly becoming important due to ease of manufacturing, extremely high film purity, plenty of available monomers, and ease of physical property improvement with the monomers, in addition to the characteristics described above.

With the miniaturization of electronic apparatuses, excellent characteristics are required for polyimides year by year. Multifunctional polyimide materials are required to simultaneously satisfy multiple characteristics such as resistance to soldering heat, dimensional stability of a polyimide film to thermal cycling or moisture absorption, transparency, adhesion strength to a metal substrate, formability, and ease of micro- and nano-processability such as through-hole formation.

In recent years, the demand for polyimides as an FPC substrate has significantly increased. The structure of a copper clad laminate or a flexible copper clad laminate (FCCL) that is used as a material of an FPC substrate is mainly classified into three types: 1) a three-layer type obtained by bonding copper foil to a polyimide film using, for example, an epoxy adhesive; 2) a adhesive-free two-layer type obtained by applying polyimide varnish to copper foil and then drying it, by applying varnish of a precursor of polyimide (polyamic acid) and then drying and imidizing it, or by forming a seed layer on a polyimide film using, for example, vapor deposition or sputtering of copper and then forming a copper layer through copper plating; and 3) a pseudo two-layer type obtained by bonding copper foil to a polyimide film using a thermoplastic polyimide as an adhesive layer.

In the case where high dimensional stability is required for a polyimide film, an adhesive-free two-layer FCCL has an advantage. However, only one side is processed in a polyimide film formation step performed by a cast method. In the case where copper foil is bonded to both sides of a polyimide film (double-sided copper clad laminate), a pseudo two-layer type obtained by a thermal lamination method has an advantage.

The double-sided copper clad laminate using polyimide includes a non-thermoplastic polyimide film as a core layer that has good dimensional stability and a low linear thermal expansion coefficient and thermoplastic polyimide layers formed on both sides of the core layer. Such a three-layered structure using polyimide film is made as follows. Thermoplastic polyimide varnish is applied to both sides of a non-thermoplastic polyimide film subjected to an adhesion enhancement process through discharge treatment and then dried. Alternatively, a precursor layer of a thermoplastic polyimide is formed on both sides of a non-thermoplastic polyimide precursor film and then imidized.

In this case, to improve the melt-flowability of the used thermoplastic polyimide, a flexible group with ether linkage or asymmetrical linkage such as metha linkage is normally introduced in a main chain of the polyimide to increase molecular motion. However, when the thermoplasticity is increased to improve the processability of a polyimide, the glass transition temperature of the polyimide is significantly decreased. In the molecular design of a polyimide, it is difficult to achieve both good thermoplasticity and high glass transition temperature.

To improve the processability of a polyimide, efforts have been made to achieve both solubility in an organic solvent (Japanese Examined Patent Application Publication No. 46-016906) and thermoplasticity. An example of a commercially available polyimide having both solubility in an organic solvent and thermoplasticity is ULTEM1000 (available from General Electric Company). However, the glass transition temperature of ULTEM1000 is 215°C, which is insufficient in consideration of resistance to soldering heat. Thus, ULTEM1000 cannot be applied to FPC use.

At present, the glass transition temperature of a thermoplastic polyimide layer used for a pseudo two-layer FCCL is about 250°C at most. However, further improvement in the glass transition temperature of a polyimide adhesive has been strongly required recently with an increase in lead-free soldering. When the soldering temperature is high, water adsorbed in an adhesive layer also contributes to an abrupt decrease in adhesive strength due to a significant temperature increase of a thermoplastic polyimide adhesive layer. Such a serious problem is pointed out.

Technologies that use tetracarboxylic dianhydride having an asymmetric structure are disclosed as effective means of improving the thermoplasticity of a polyimide without sacrificing glass transition temperature (refer to, for example, Macromolecules, vol. 32, 387 (1999); Japanese Unexamined Patent Application Publication No. 8-319470; and Japanese Unexamined Patent Application Publication (Translation of PCT Application) Nos. 2006-510061 and 2006-509888). According to these technologies, asymmetric 2,3,3',4'-biphenyltetracarboxylic dianhydride (a-BPDA) represented by Formula (6) is used instead of existing symmetric 3,3',4,4'-biphenyltetracarboxylic dianhydride (s-BPDA) represented by Formula (5). By combining the compound with a suitable flexible diamine, a polyimide having both high glass transition temperature and thermoplasticity can be achieved.

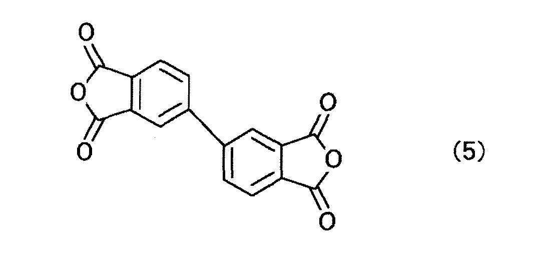

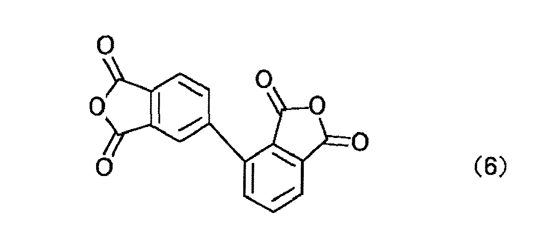

However, a polyimide obtained using a-BPDA does not always satisfy solubility in an organic solvent and film toughness. If a polyimide satisfying all of high solubility in an organic solvent, good thermoplasticity, and high film toughness while having high glass transition temperature was obtained, an unprecedented high-temperature adhesive material that is significantly useful for a pseudo two-layer FCCL could be provided. Unfortunately, such a material is not known.

Accordingly, an object of the present invention is to provide a polyimide having good processability, that is, solubility and thermoplasticity better than before and also having high glass transition temperature and high toughness; a precursor of the polyimide; and a method for manufacturing them. Furthermore, another object of the present invention is to provide a heat-resistant adhesive, a copper clad laminate (CCL), and a flexible printed circuit (FPC) that uses the polyimide.

### Disclosure of Invention

The objects described above are achieved with the present invention.

The present invention provides a linear polyimide precursor comprising a repeating unit represented by at least one formula selected from the group consisting of General Formula (1) and General Formula (2), the linear polyimide precursor having an intrinsic viscosity of 0.5 dL/g or more. 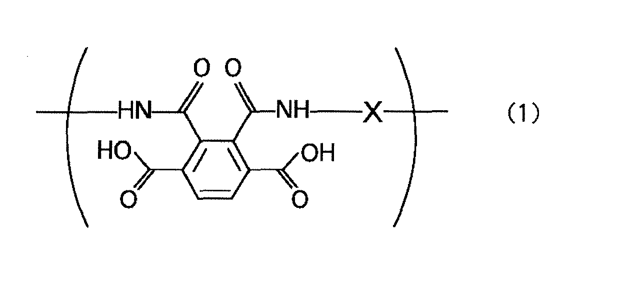 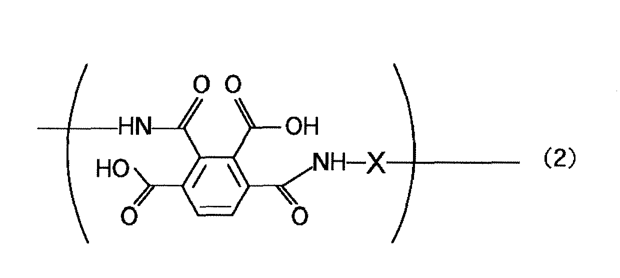 (In General Formulas (1) and (2), X is a divalent aromatic group or a divalent aliphatic group excluding residues of 1,4-bis(4-aminophenoxy)benzene and bis(4-amino-3-methylphenyl)methane.)

In the linear polyimide precursor, the X is preferably a divalent group containing a group represented by General Formula (3), and assuming that Y is a mole fraction of the group represented by General Formula (3) relative to the X, the Y is preferably 0.1 to 1.0. 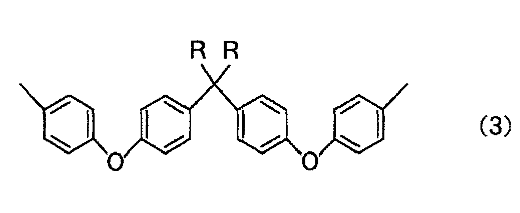 (In General Formula (3), two Rs are both methyl groups or both trifluoromethyl groups, or one of the two Rs is a methyl group and the other is a trifluoromethyl group.)

The present invention provides a method for manufacturing any of the linear polyimide precursors described above, wherein at least one kind of monomer selected from mellophanic dianhydride and its derivatives and a diamine monomer excluding 1,4-bis(4-aminophenoxy)benzene and bis(4-amino-3-methylphenyl)methane are polymerized in an organic solvent in which the total monomer concentration is 10 to 50% by mass until a solution viscosity reaches its maximum.

The present invention provides a polyimide comprising a repeating unit represented by General Formula (4), the polyimide having an intrinsic viscosity of 0.5 dL/g or more. 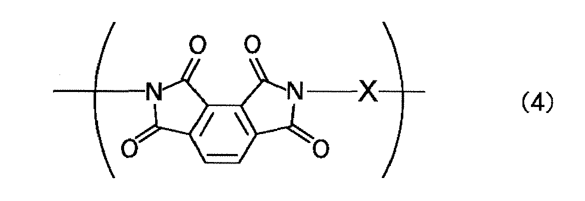 (In General Formula (4), X is a divalent aromatic group or a divalent aliphatic group excluding residues of 1,4-bis(4-aminophenoxy)benzene and bis(4-amino-3-methylphenyl)methane.)

In the polyimide, the X is preferably a divalent group containing a group represented by General Formula (3), and assuming that Z is a mole fraction of the group represented by General Formula (3) relative to the X, the Z is preferably 0.1 to 1.0. 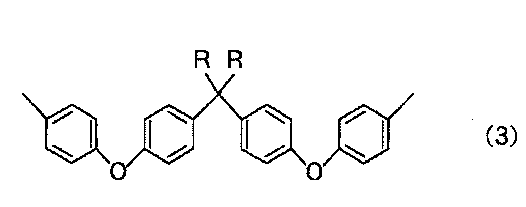 (In General Formula (3), two Rs are both methyl groups or both trifluoromethyl groups, or one of the two Rs is a methyl group and the other is a trifluoromethyl group.)

Any of the polyimides described above preferably has a glass transition temperature of 270°C or higher, a solubility in an aprotic organic solvent of 10% or more by mass, a peel strength of 0.8 kgf/cm or more when a laminate is made together with copper foil, and film toughness with an elongation of 10% or more.

The present invention provides a method for manufacturing any of the polyimides described above, wherein a solution of any of the linear polyimide precursors described above is processed using at least one selected from the group consisting of heat and a cyclodehydration reagent.

The present invention provides a method for manufacturing any of the polyimides described above, wherein at least one kind of monomer selected from mellophanic dianhydride and its derivatives is allowed to react with a diamine monomer excluding 1,4-bis(4-aminophenoxy)benzene and bis(4-amino-3-methylphenyl)methane in a solvent through a one-pot polycondensation reaction without isolating the corresponding reaction intermediate.

The present invention provides a heat-resistant adhesive comprising any of the polyimides described above.

The present invention provides a copper clad laminate comprising the heat-resistant adhesive, a non-thermoplastic polyimide film, and copper foil.

The present invention provides a flexible printed circuit comprising the copper clad laminate.

The present invention provides a flexible printed circuit obtained by etching a copper layer of the copper clad laminate.

The present invention provides a linear polyimide precursor comprising a repeating unit represented by General Formula (1) or General Formula (2), the linear polyimide precursor having an intrinsic viscosity of 0.5 dL/g or more. 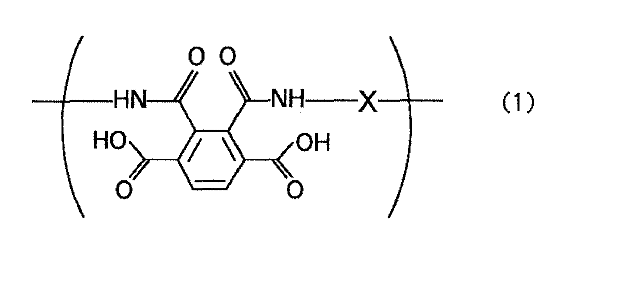 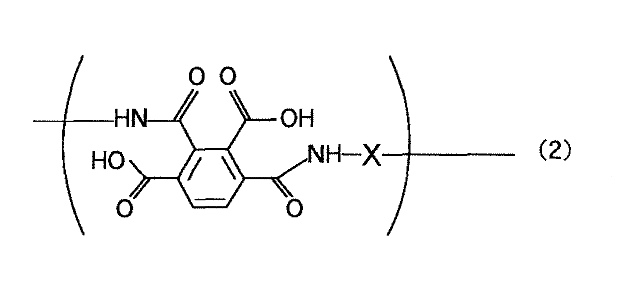 (In General Formulas (1) and (2), X is a divalent aromatic group or a divalent aliphatic group excluding residues of 1,4-bis(4-aminophenoxy)benzene and bis(4-amino-3-methylphenyl)methane.)

### Brief Description of Drawings

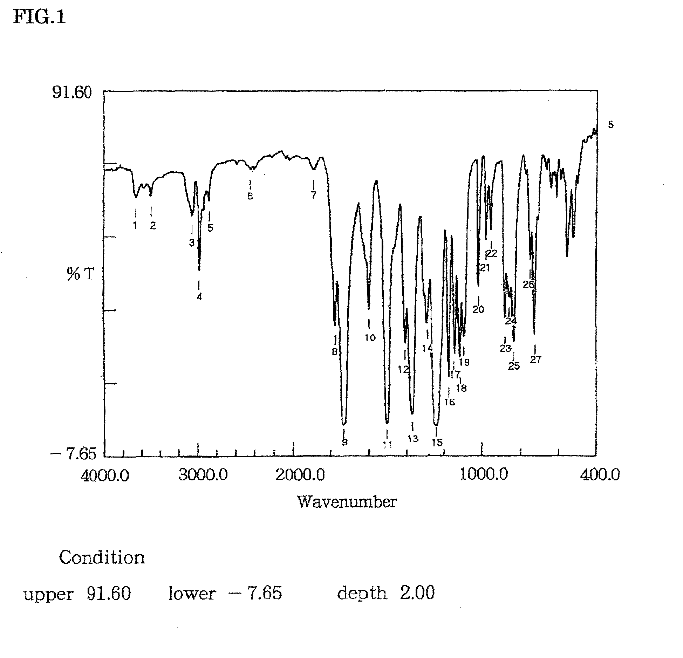

[Fig. 1] Fig. 1 shows an infrared absorption spectrum of the polyimide film described in Example 1. The peaks in Fig. 1 are shown below.

| | | |
|---|---|---|
| 1 : 3647.72 (62.4) | 2 : 3491.47 (63.1) | 3 : 3053.59 (57.5) |
| 4 : 2968.71 (42.7) | 5 : 2874.19 (61.6) | 6 : 2447.89 (70.1) |
| 7 : 1892.34 (69.9) | 8 : 1774.67 (27.7) | 9 : 1738.02 (0.8) |
| 10 : 1597.20 (32.1) | 11 : 1502.68 (1.1) | 12 : 1404.30 (22.9) |
| 13 : 1371.51 (3.7) | 14 : 1290.49 (28.3) | 15 : 1246.13 (0.6) |
| 16 : 1172.83 (13.9) | 17 : 1141.96 (19.9) | 18 : 1114.96 (18.9) |
| 19 : 1093.74 (24.7) | 20 : 1014.65 (38.2) | 21 : 976.07 (50.9) |
| 22 : 952.92 (53.5) | 23 : 875.76 (29.4) | 24 : 854.54 (35.4) |
| 25 : 831.39 (23.0) | 26 : 746.52 (45.6) | 27 : 725.30 (25.3) |

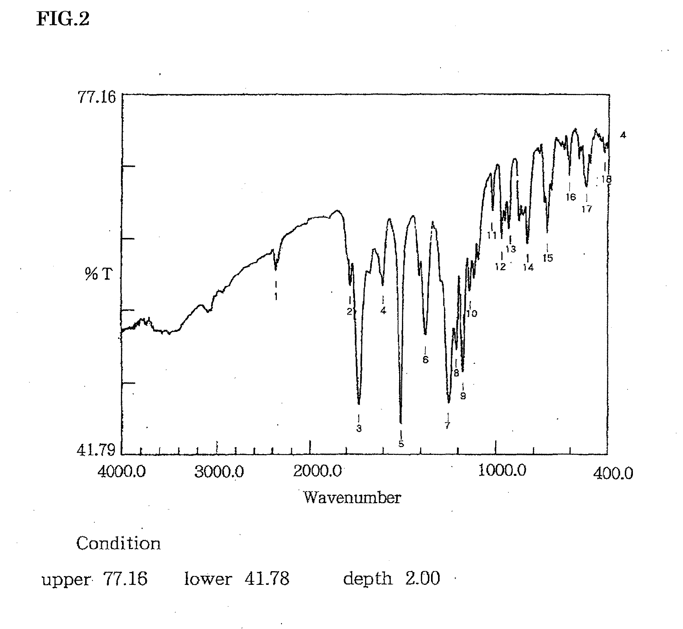

[Fig. 2] Fig. 2 shows an infrared absorption spectrum of the polyimide film described in Example 2. The peaks in Fig. 2 are shown below.

| | | |
|---|---|---|
| 1 : 2363.01 (59.9) | 2 : 1776.60 (58.3) | 3 : 1732.23 (46.6) |
| 4 : 1601.06 (58.3) | 5 : 1502.68 (44.7) | 6 : 1371.51 (53.5) |
| 7 : 1248.06 (46.8) | 8 : 1207.55 (52.0) | 9 : 1174.75 (50.0) |
| 10 : 1138.10 (57.8) | 11 : 1016.58 (65.7) | 12 : 968.35 (63.0) |
| 13 : 929.77 (64.0) | 14 : 831.39 (62.5) | 15 : 725.30 (63.5) |
| 16 : 609.56 (69.2) | 17 : 516.97 (68.0) | 18 : 420.52 (71.4) |

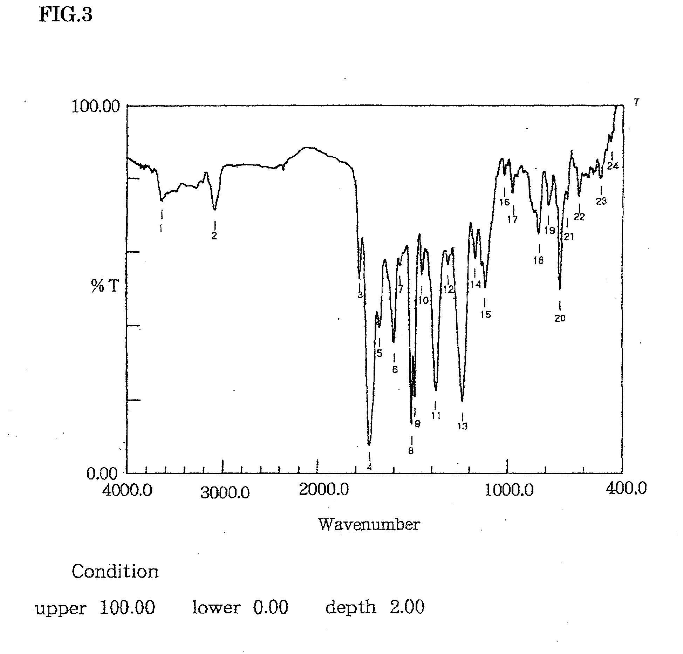

[Fig. 3] Fig. 3 shows an infrared absorption spectrum of the polyimide film described in Example 3. The peaks in Fig. 3 are shown below.

| | | |
|---|---|---|
| 1 : 3630.36 (73.8) | 2 : 3084.45 (71.2) | 3 : 1776.60 (52.6) |
| 4 : 1726.45 (7.6) | 5 : 1672.43 (39.4) | 6 : 1957.20 (35.3) |
| 7 : 1564.41 (56.2) | 8 : 1506.54 (13.2) | 9 : 1487.25 (20.9) |
| 10 : 1446.74 (53.6) | 11 : 1337.30 (22.4) | 12 : 1311.71 (56.4) |
| 13 : 1238.41 (19.5) | 14 : 1167.04 (58.2) | 15 : 1114.96 (50.3) |
| 16 : 1014.65 (80.7) | 17 : 976.07 (76.0) | 18 : 837.18 (64.7) |
| 19 : 785.10 (72.7) | 20 : 725.30 (49.5) | 21 : 686.72 (74.4) |
| 22 : 626.92 (75.1) | 23 : 515.04 (80.0) | 24 : 462.96 (90.0) |

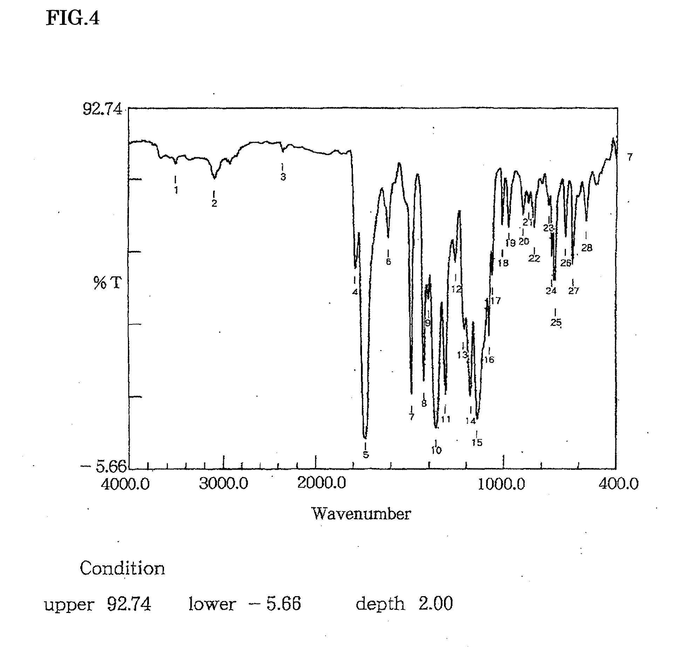

[Fig. 4] Fig. 4 shows an infrared absorption spectrum of the polyimide film described in Example 4. The peaks in Fig. 4 are shown below.

| | | |
|---|---|---|
| 1 : 3504.97 (77.1) | 2 : 3096.03 (73.2) | 3 : 2361.08 (80.5) |
| 4 : 1786.24 (48.7) | 5 : 1734.16 (2.5) | 6 : 1614.56 (57.0) |
| 7 : 1491.11 (14.6) | 8 : 1425.52 (18.2) | 9 : 1402.38 (40.4) |
| 10 : 1363.80 (5.4) | 11 : 1311.71 (14.5) | 12 : 1257.70 (50.5) |
| 13 : 1209.48 (32.2) | 14 : 1178.61 (14.3) | 15 : 1141.96 (8.0) |
| 16 : 1076.38 (30.3) | 17 : 1059.02 (47.0) | 18 : 1006.93 (60.7) |
| 19 : 976.07 (59.9) | 20 : 895.05 (63.2) | 21 : 868.05 (66.7) |
| 22 : 839.11 (59.7) | 23 : 760.02 (66.0) | 24 : 742.66 (52.2) |
| 25 : 723.37 (41.3) | 26 : 669.36 (57.1) | 27 : 626.92 (49.9) |
| 28 : 555.55 (61.7) | | |

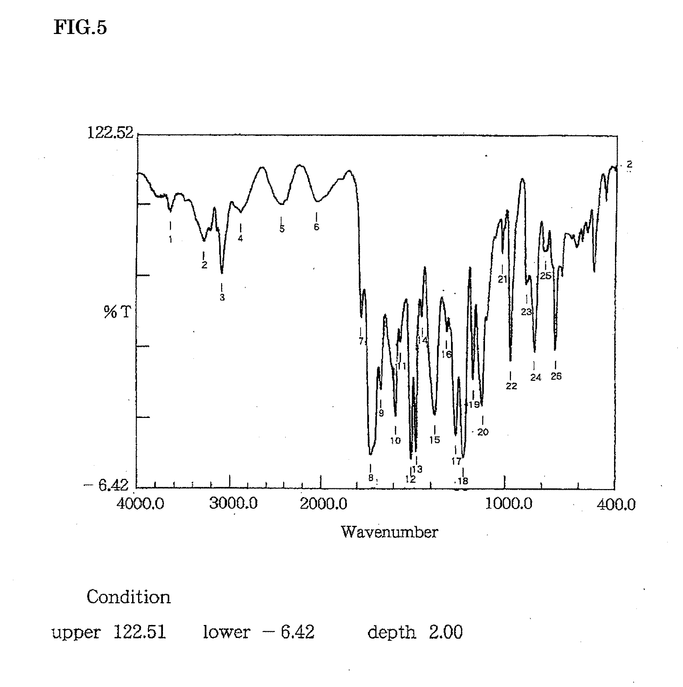

[Fig. 5] Fig. 5 shows an infrared absorption spectrum of the polyimide film described in Example 5. The peaks in Fig. 5 are shown below.

| | | |
|---|---|---|
| 1 : 3645.79 (94.0) | 2 : 3275.42 (83.4) | 3 : 3082.53 (71.5) |
| 4 : 2889.63 (94.0) | 5 : 2444.03 (96.6) | 6 : 2052.44 (97.9) |
| 7 : 1776.60 (55.7) | 8 : 1726.45 (6.0) | 9 : 1672.43 (29.8) |
| 10 : 1593.35 (20.1) | 11 : 1564.41 (47.0) | 12 : 1506.54 (4.3) |
| 13: 1479.53 (7.3) | 14: 1446.74 (56.0) | 15 : 1379.23 (20.5) |
| 16 : 1311.71 (50.6) | 17 : 1265.42 (13.1) | 18 : 1222.98 (5.1) |
| 19 : 1170.90 (33.4) | 20 : 1122.67 (23.6) | 21 : 1014.65 (79.1) |
| 22 : 968.35 (40.0) | 23 : 881.55 (68.0) | 24 : 835.25 (43.4) |
| 25: 779.31 (80.0) | 26 : 725.30 (43.9) | |

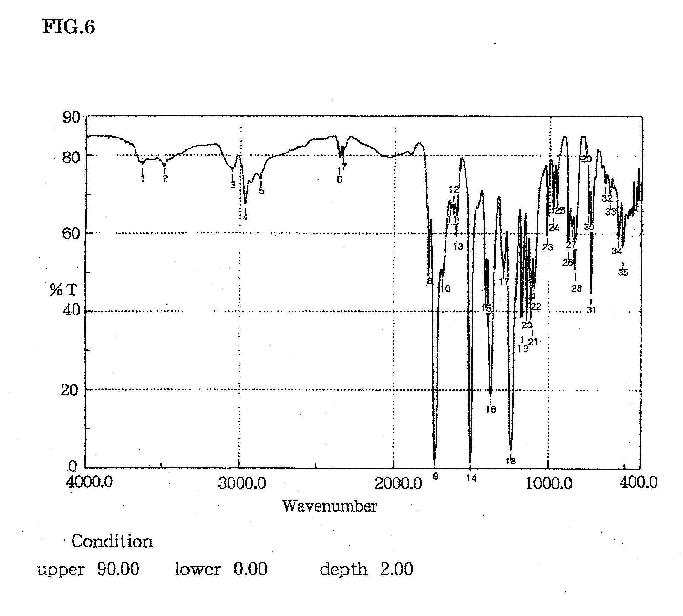

[Fig. 6] Fig. 6 shows an infrared absorption spectrum of the polyimide film described in Example 6. The peaks in Fig. 6 are shown below.

| | | |
|---|---|---|
| 1 : 3629.37 (77.7) | 2 : 3487.63 (77.0) | 3 : 3050.83 (76.0) |
| 4 : 2967.91 (67.6) | 5 : 2872.45 (73.8) | 6 : 2359.48 (79.2) |
| 7 : 2339.23 (80.7) | 8 : 1774.19 (50.4) | 9 : 1731.76 (2.3) |
| 10 : 1683.55 (48.8) | 11 : 1635.34 (66.4) | 12 : 1616.06 (66.5) |
| 13 : 1596.77 (59.3) | 14 : 1501.31 (1.26) | 15 : 1404.89 (43.1) |
| 16 : 1372.10 (18.9) | 17 : 1292.07 (50.9) | 18 : 1240.97 (4.7) |
| 19 : 1172.51 (38.2) | 20 : 1141.65 (40.3) | 21 : 1113.69 (38.2) |
| 22 : 1093.44 (45.9) | 23 : 1014.37 (59.6) | 24 : 975.80 (65.6) |
| 25 : 951.70 (69.1) | 26 : 875.52 (56.0) | 27 : 853.35 (62.1) |
| 28 : 832.13 (50.7) | 29 : 771.39 (81.7) | 30 : 746.32 (65.3) |
| 31 : 725.10 (44.4) | 32 : 640.25 (73.0) | 33 : 609.40 (68.9) |
| 34 : 550.58 (58.6) | 35 : 521.65 (56.7) | |

### Best Modes for Carrying Out the Invention

The present invention will now be described in detail with best modes for carrying out the invention.

### <Molecular Design>

A linear polyimide precursor of the present invention and tetracarboxylic dianhydride (monomer) used for manufacturing a polyimide are described.

According to the present invention, instead of pyromellitic dianhydride (hereinafter referred to as PMDA) that has been used as a general tetracarboxylic dianhydride component and is represented by Formula (7), mellophanic dianhydride (hereinafter referred to as MPDA) that is an isomer of PMDA and is represented by Formula (8) is used. Consequently, a polyimide that satisfies all of the target properties can be obtained.

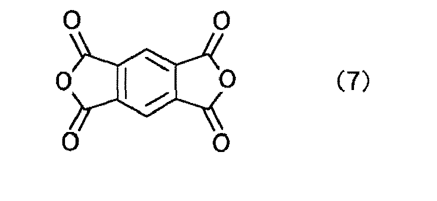

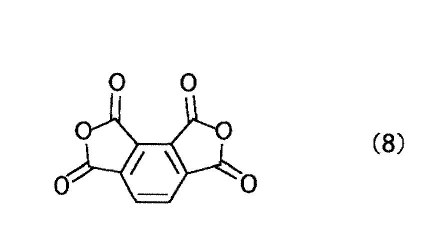

An existing polyimide obtained using PMDA has a linear structure at a diimide site. In contrast, a polyimide obtained using MPDA has a three-dimensional bent structure in its main chain. This causes stacking of a polymer chain, which provides high thermoplasticity. Furthermore, it is believed that, since local internal rotation at a mellophanic acid site is suppressed, high glass transition temperature is achieved.

Such a bent structure in a main chain can be also introduced by using methaphenylenediamine represented by Formula (9) as a diamine component. However, the use of methaphenylenediamine hardly contributes to improvement in solubility of the obtained polyimide in an organic solvent and often causes an unfavorable result including a significant decrease in glass transition temperature.

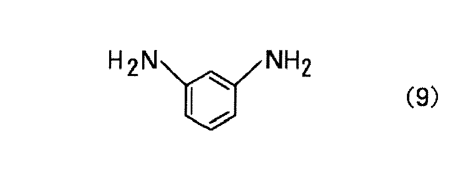

A diamine having ether linkage is preferably used for polymerization with MPDA. This combination is effective to simultaneously achieve high solubility, high thermoplasticity, and high toughness of the obtained polyimide. However, when 4,4'-oxydianiline (hereinafter referred to as 4,4'-ODA) that is a general diamine containing an ether group is used, the obtained polyimide may have unsatisfactory solubility. The inventors have found that a polyimide having high toughness can be obtained without sacrificing its solubility by preferably using a diamine represented by General Formula (10) that has a structural unit of a main chain of polycarbonate, which is a representative highly tough resin.

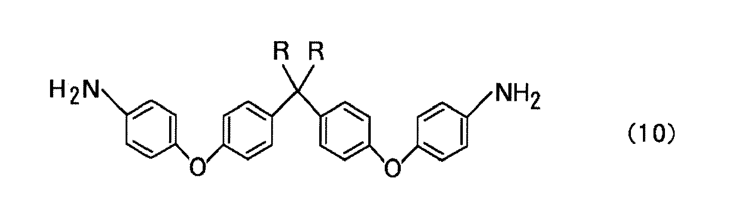

In General Formula (10), two Rs are both methyl groups or both trifluoromethyl groups, or one of two Rs is a methyl group and the other is a trifluoromethyl group.

When the diamine (General Formula (10)) described above is used as a raw material of the linear polyimide precursor and the polyimide of the present invention, the diamine is preferably used in a range of 10 to 100 mol% (mole fraction 0.1 to 1.0) of the entire diamine, more preferably 30 to 100 mol%. In the case where the ratio of the diamine to the entire diamine is 10% (mole fraction 0.1) or more, the solubility and thermoplasticity of the obtained polyimide are easily achieved. Other preferable diamines used together with the diamine represented by General Formula (10) are not particularly limited. Examples of such preferable diamines include 4,4'-oxydianiline and 3,4'-oxydianiline.

In consideration of manufacturing costs and adhesion strength between copper foil and the polyimide of the present invention with an adhesive provided therebetween, 2,2-bis(4-(4-aminophenoxy)phenyl)propane (hereinafter referred to as BAPP) represented by Formula (11) is the best as the used diamine.

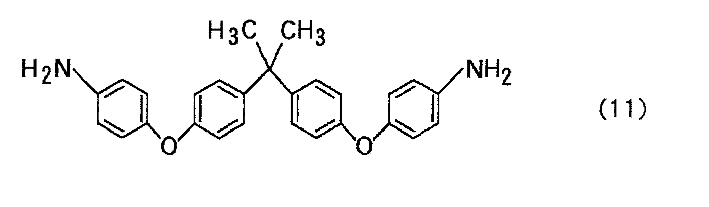

### <Control of Cyclic Oligomer Formation during Manufacturing of linear polyimide precursor>

A method for manufacturing a linear polyimide precursor and a polyimide of the present invention will now be described.

When a linear polyimide precursor or a polyimide is manufactured by combining MPDA and a diamine, a cyclic imide and/or a cyclic amide (both called cyclic oligomers) exemplified as Formula (12) tends to be produced due to the binding position of an acid anhydride group that is a distinctive characteristic of MPDA. This is disclosed in Macromolecules, vol. 35, 8708 (2002). Therefore, there is a problem in that a desirable high-molecular-weight linear polyimide precursor is not easily obtained.

Since the cyclic oligomer described below has a low molecular weight, entanglement of polymer chains hardly occurs. Although it is expected that such a cyclic oligomer has higher thermoplasticity and solubility than the corresponding linear polymer, the cyclic oligomer may have significantly decreased film toughness and possibly does not function as an adhesive resin. Accordingly, the polyimide of the present invention is preferably a linear polyimide. However, such a cyclic polyimide is not excluded unless the object of the present invention is lost. For example, a cyclic polyimide may be mixed in a linear polyimide.

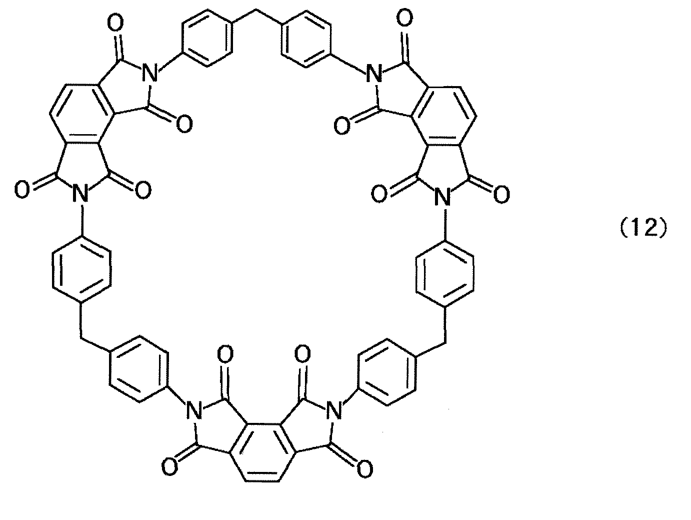

When a highly symmetric flexible diamine such as 4,4'-methylenedianiline, 4,4'-oxydianiline, or 1,4-bis(4-aminophenoxy)benzene is used alone as a diamine to react with MPDA, the cyclic imide represented by Formula (12) tends to be easily produced. Therefore, it is effective to use an asymmetric diamine such as 3,4'-oxydianiline to obtain a high-molecular-weight linear polyimide precursor and a high-molecular-weight polyimide.

Even if a highly symmetric flexible diamine such as 4,4'-methylenedianiline is used as described above, a high-molecular-weight linear polyimide precursor (polyamic acid) is produced once at the beginning of the polymerization reaction, which causes a rapid increase in viscosity of the polymerization reaction solution. However, an amide exchange reaction then occurs between the amide bonds adjacent to each other at positions that are advantageous to ring formation because of the flexibility of the diamine. As a result, the diamine is converted into a stable cyclic amide, which causes a rapid decrease in viscosity of the solution. Thus, in the linear polyimide precursor of the present invention, the conversion into a cyclic oligomer is suppressed by dropping the polymerization reaction solution into a poor solvent when the viscosity of the polymerization solution becomes the highest through viscosity tracking. Consequently, a high-molecular-weight linear polyimide precursor can be isolated.

A high-molecular-weight polyimide can be manufactured by inserting a cyclodehydration reagent into the polymerization solution or by causing a cyclodehydration reaction (imidization reaction) through the heating of the polymerization solution when the viscosity of the polymerization solution becomes the highest. Once imidization has been completed, conversion into such a cyclic oligomer never occurs. The cyclodehydration reagent herein is a reagent that facilitates a condensation reaction by removing water produced through a dehydration-condensation reaction. Examples of the reagent include reagents that react with water of an acid anhydride or the like, water-adsorbing agents such as zeolites and silica gels, hydrate absorption agents such as sodium sulfate, and materials such as toluene that form an azeotropic mixture with water. Above all, an acid anhydride or a mixture of an acid anhydride and amines is preferable. Acetic anhydride or a mixture of acetic anhydride and tertiary amines is more preferable. In particular, a mixture obtained by combining acetic anhydride with pyridine, quinoline, and/or triethylamine is suitably used.

In the case where monomer concentration is low when a linear polyimide precursor is manufactured, an intramolecular reaction preferentially occurs compared with an intermolecular reaction, which easily produces a cyclic oligomer. Therefore, to obtain a high-molecular-weight linear polyimide precursor, it is effective to adjust monomer concentration as high as possible. In the present invention, polymerization is preferably performed at a total monomer concentration of 10 to 50% by mass until the solution viscosity reaches its maximum.

It is also important to select a solvent used for the polymerization when a linear polyimide precursor is manufactured. To obtain a high-molecular-weight linear polyimide precursor, it is effective to use a solvent possessing higher affinity with the linear polyimide precursors of the present invention. In a high affinity solvent, solvent molecules enter polymer chain coils to stretch the polymer chain. As a result, a cyclic oligomer is not easily produced due to the reaction between end terminals. In polymerization reactions of a linear polyimide precursor that use MPDA and a diamine, the viscosity of the polymerization solution is slowly decreased by using N-methyl-2-pyrrolidone (NMP) compared with N,N-dimethylacetamide (DMAc) among general amide solvents. From the viewpoints, N-methyl-2-pyrrolidone is a suitable solvent for manufacturing a high-molecular-weight linear polyimide precursor.

### <Method for Manufacturing Linear Polyimide Precursor>

A method for manufacturing the linear polyimide precursor of the present invention will now be described in detail. The linear polyimide precursor is manufactured as follows. First, a diamine component (monomer) is dissolved in a polymerization solvent, and mellophanic dianhydride (monomer) powder that is represented by Formula (8) and is substantially equimolar to the diamine is gradually added to the solution. The solution is then stirred using a mechanical stirrer at room temperature for 0.5 to 48 hours. The total monomer concentration is 10 to 50% by mass, preferably 20 to 40% by mass. A homogeneous solution of linear polyimide precursor with high degree of polymerization can be obtained by performing polymerization in that total monomer concentration range.

A linear polyimide precursor with a higher degree of polymerization tends to be obtained at higher monomer concentrations. Therefore, polymerization is preferably initiated at as high a monomer concentration as possible to ensure the toughness of the resulting polyimide. Furthermore, a polymerization reaction time when the solution viscosity reaches its maximum is desirably determined accurately by measuring the viscosity of the polymerization reaction solution through frequent sampling or by tracking viscosity change using a stirrer with a torquemeter to perform imidization at that timing.

The polymerization solvent is not particularly limited. Examples of the polymerization solvent include aprotic solvents such as N-methyl-2-pyrrolidone (NMP), N,N-dimethylacetamide (DMAc), N,N-diethylacetamide, N,N-dimethylformamide, hexamethylphosphoramide, dimethyl sulfoxide, γ-butyrolactone, 1,3-dimethyl-2-imidazolidinone, 1,2-dimethoxyethane-bis(2-methoxyethyl)ether, tetrahydrofuran, 1,4-dioxane, picoline, pyridine, acetone, chloroform, toluene, and xylene; and protic solvents such as phenol, o-cresol, m-cresol, p-cresol, o-chlorophenol, m-chlorophenol, and p-chlorophenol. These solvents may be used alone or in combination. Because the viscosity of the polymerization reaction solution is slowly decreased, N-methyl-2-pyrrolidone is suitably used.

In the present invention, it is regarded to be soluble in the case where the solubility in at least one kind of solvent among the above-mentioned aprotic solvents is 10% or more by mass.

In the range where the target properties of the polyimides of the present invention are practically maintained, the aromatic diamines used here are not particularly limited. Examples of the aromatic diamines include 2,2'-bis(trifluoromethyl)benzidine, p-phenylenediamine, m-phenylenediamine, 2,4-diaminotoluene, 2,5-diaminotoluene, 2,4-diaminoxylene, 2,4-diaminodurene, 4,4'-diaminodiphenylmethane, 4,4'-methylene bis(2-methylaniline), 4,4'-methylene bis(2-ethylaniline), 4,4'-methylene bis(2,6-dimethylaniline), 4,4'-methylene bis(2,6-diethylaniline), 4,4'-diaminodiphenyl ether, 3,4'-diaminodiphenyl ether, 3,3'-diaminodiphenyl ether, 2,4'-diaminodiphenyl ether, 4,4'-diaminodiphenyl sulfone, 3,3'-diaminodiphenyl sulfone, 4,4'-diaminobenzophenone, 3,3'-diaminobenzophenone, 4,4'-diaminobenzanilide, benzidine, 3,3'-dihydroxybenzidine, 3,3'-dimethoxybenzidine, o-tolidine, m-tolidine, 1,3-bis(4-aminophenoxy)benzene, 1,3-bis(3-aminophenoxy)benzene, 4,4'-bis(4-aminophenoxy)biphenyl, bis(4-(3-aminophenoxy)phenyl) sulfone, bis(4-(4-aminophenoxy)phenyl) sulfone, 2,2-bis(4-(4-aminophenoxy)phenyl)propane, 2,2-bis(4-(4-aminophenoxy)phenyl)hexafluoropropane, 2,2-bis(4-aminophenyl)hexafluoropropane, and p-terphenylenediamine. These aromatic diamines can be used in combination.

In the present invention, 1,4-bis(4-aminophenoxy)benzene and bis(4-amino-3-methylphenyl)methane can also be exemplified. However, they cannot be used alone as a diamine monomer. This is because, in the case where bis(4-amino-3-methylphenyl)methane is used alone, the elongation at break is as low as 2 to 3% when a polyimide has been completed, which poses a considerable problem of mechanical strength, as described in Macromolecules, vol. 35, 8708 (2002). Moreover, in the case where 1,4-bis(4-aminophenoxy)benzene is used alone, the obtained polyimide has low solubility in representative aprotic solvents such as NMP, DMSO, and DMAc, which causes low processability.

In terms of suppressing the cyclic oligomer formation when the obtained linear polyimide precursor is manufactured and also ensuring thermoplasticity and solubility of the polyimide, flexible diamines can be suitably used. Examples of the flexible diamines include 2,2-bis(4-(4-aminophenoxy)phenyl)propane, 2,2-bis(4-(4-aminophenoxy)phenyl)hexafluoropropane, 2,2-bis(4-aminophenyl)hexafluoropropane, 3,4'-diaminodiphenyl ether, 3,3'-diaminodiphenyl ether, 2,4'-diaminodiphenyl ether, 4,4'-diaminodiphenyl sulfone, and 3,3'-diaminodiphenyl sulfone.

In the range where the target properties of the polyimides of the present invention are practically maintained, aliphatic diamines also can be used without limitation. Examples of the aliphatic diamines include trans-1,4-diaminocyclohexane, cis-1,4-diaminocyclohexane, 1,4-diaminocyclohexane (trans/cis mixture), 1,3-diaminocyclohexane, isophoronediamine, 1,4-cyclohexane bis(methylamine), 2,5-bis(aminomethyl)bicyclo[2.2.1]heptane, 2,6-bis(aminomethyl)bicyclo[2.2.1]heptane, 3,8-bis(aminomethyl)tricyclo[5.2.1.0]decane, 1,3-diaminoadamantane, 4,4'-methylene bis(cyclohexylamine), 4,4'-methylene bis(2-methylcyclohexylamine), 4,4'-methylene bis(2-ethylcyclohexylamine), 4,4'-methylene bis(2,6-dimethylcyclohexylamine), 4,4'-methylene bis(2,6-diethylcyclohexylamine), 2,2-bis(4-aminocyclohexyl)propane, 2,2-bis(4-aminocyclohexyl)hexafluoropropane, 1,3-propanediamine, 1,4-tetramethylenediamine, 1,5-pentamethylenediamine, 1,6-hexamethylenediamine, 1,7-heptamethylenediamine, 1,8-octamethylenediamine, and 1,9-nonamethylenediamine. These aliphatic diamines can be used in combination.

Copolymerization may be performed partly using a tetracarboxylic dianhydride component other than MPDA as long as the target properties and polymerization reactivity of the polyimide of the present invention are not significantly impaired. Dianhydrides that can be used for copolymerization are not particularly limited. Examples of the dianhydrides include aromatic tetracarboxylic dianhydrides such as pyromellitic dianhydride, 3,3',4,4'-biphenyltetracarboxylic dianhydride, 3,3',4,4'-benzophenonetetracarboxylic dianhydride, 3,3',4,4'-biphenyl ether tetracarboxylic dianhydride, 3,3',4,4'-biphenyl sulfone tetracarboxylic dianhydride, 2,2'-bis(3,4-dicarboxyphenyl)hexafluoropropanoic dianhydride, 2,2'-bis(3,4-dicarboxyphenyl)propanoic dianhydride, 1,4,5,8-naphthalenetetracarboxylic dianhydride, and 2,3,6,7-naphthalenetetracarboxylic dianhydride; and alicyclic tetracarboxylic dianhydrides such as bicyclo[2.2.2]oct-7-ene-2,3,5,6-tetracarboxylic dianhydride, 5-dioxotetrahydrofuryl-3-methyl-3-cyclohexene-1,2-dicarboxylic anhydride, 4-(2,5-dioxotetrahydrofuran-3-yl)-tetralin-1,2-dicarboxylic anhydride, tetrahydrofuran-2,3,4,5-tetracarboxylic dianhydride, bicyclo-3,3',4,4'-tetracarboxylic dianhydride, 3c-carboxymethylcyclopentane-1r,2c,4c-tricarboxylic acid 1,4:2,3-dianhydride, 1,2,4,5-cyclohexanetetracarboxylic dianhydride, 1,2,3,4-cyclobutanetetracarboxylic dianhydride, and 1,2,3,4-cyclopentanetetracarboxylic dianhydride. These dianhydrides may be used alone or in combination as a copolymerization component.

The linear polyimide precursor and the polyimide of the present invention are used as a film by applying the solution (varnish) thereof to a substrate and then by drying it. In addition, the linear polyimide precursor and the polyimide of the present invention are obtained as powder by properly diluting the varnish, dropping the varnish into a poor solvent such as a large amount of water or methanol to produce precipitate, and filtering and drying the precipitate.

The intrinsic viscosity of the linear polyimide precursor and the polyimide of the present invention is desirably as high as possible in terms of toughness of a polyimide film. The intrinsic viscosity is 0.5 dL/g or more, preferably 1.0 dL/g or more, more preferably 1.5 dL/g or more. When the intrinsic viscosity is less than 0.5 dL/g, the film formability of a polyimide is significantly reduced, which poses a serious problem in that the cast film of the polyimide is cracked, or sufficient adhesive strength cannot be achieved when the polyimide is used as an FCCL adhesive layer. The intrinsic viscosity is desirably less than 5.0 dL/g in terms of handling of varnish of the linear polyimide precursor and the polyimide.

### <Method for Manufacturing Polyimide>

The polyimide of the present invention can be manufactured by a dehydration-cyclization reaction (imidization reaction) of the linear polyimide precursor obtained through the above-mentioned method. In this case, the applicable forms of the polyimides are a film, a metal-substrate/polyimide-film laminate, powder, a molded form, and a solution.

A method for manufacturing a polyimide film is described first. A solution (varnish) of the linear polyimide precursor is cast on a substrate composed of an insoluble polyimide film, glass, copper, aluminum, stainless steel, or silicon, and then dried in an oven at 40 to 180°C, preferably at 50 to 150°C. The polyimide film of the present invention can be manufactured by heating the obtained linear polyimide precursor film on the substrate under vacuum, under an inert gas such as nitrogen, or in the air at 200 to 400°C, preferably at 250 to 350°C. The heating temperature is preferably 200°C or more to ensure complete thermal imidization and preferably 400°C or less in view of thermal stability of the formed polyimide film. The imidization is desirably performed under vacuum or in an inert gas atmosphere, but may be performed in the air unless the imidization temperature is too high.

Instead of the heat treatment, the imidization reaction can be performed by immersing the linear polyimide precursor film into the solution containing a cyclodehydration reagent such as acetic anhydride in the presence of a tertiary amine such as pyridine or triethylamine. Furthermore, polyimide varnish can be obtained by adding a cyclodehydration reagent into a linear polyimide precursor varnish preliminarily and then by stirring it at 20 to 100°C for 0.5 to 24 hours. After the polyimide varnish is dropped into a poor solvent such as water or methanol, the precipitate formed is collected by filtration. Consequently, polyimide powder can be isolated. A polyimide film can be made by casting the polyimide varnish on the substrate described above and then by drying it. The polyimide film may be additionally annealed under the thermal conditions described above.

In the case where the polyimide itself can be dissolved in the solvent used for the polymerization, the polyimide solution (varnish) of the present invention can be easily prepared by heating a varnish of the linear polyimide precursor obtained from the polymerization reaction to 150 to 200°C with or without properly dilution with the same solvent.

In the case where the polyimide itself is insoluble in a solvent, polyimide powder can be obtained as a precipitate. In this case, toluene or xylene may be added to perform azeotropic distillation so as to remove water that is a by-product of the imidization reaction. A base such as γ-picoline can be added as a catalyst. After the imidized reaction, the reaction solution is dropped into a poor solvent such as water or methanol, the precipitate is collected by filtration. Consequently, polyimide powder can be isolated. The polyimide powder can be dissolved in the polymerization solvent again to obtain polyimide varnish.

The polyimide of the present invention can be manufactured through a one-pot polycondensation without isolating the corresponding reactive intermediate by causing a reaction between tetracarboxylic dianhydride and a diamine in a solvent at a high temperature. Although the reactive intermediate is normally composed of polyamic acid such as the linear polyimide precursor of the present invention, the reactive intermediate may contain other reactive intermediates or unreacted raw materials. In this case, the reaction solution may be held at 130 to 250°C, preferably 150 to 200°C, in terms of reaction promotion. In the case where the polyimide is insoluble in the solvent, the polyimide is obtained as a precipitate. In the case where the polyimide is soluble in the solvent, the polyimide is obtained as varnish.

The reaction solvent is not particularly limited. Examples of the reaction solvent that can be used include aprotic solvents such as N,N-dimethylformamide, N,N-dimethylacetamide, N-methyl-2-pyrrolidone, and dimethyl sulfoxide. More preferably, phenol solvents such as m-cresol or amide solvents such as NMP are used. Toluene or xylene can be added to the solvents to perform azeotropic distillation so as to remove water that is a by-product of the imidization reaction.

A base such as γ-picoline can be added as an imidization catalyst. After the solution that has reacted is dropped into a poor solvent such as a large amount of water or methanol, the precipitate is collected by filtration. Consequently, a polyimide can be isolated as powder. In the case where the polyimide is soluble in the solvent, the powder can be dissolved in the solvent again to obtain polyimide varnish. The polyimide film of the present invention can also be formed by applying the polyimide varnish to a substrate and then by drying it at 40 to 400°C, preferably at 100 to 350°C. In addition, a molded form of the polyimide can be made by heat compressing the obtained polyimide powder described above at 200 to 450°C, preferably at 250 to 430°C.

A polyisoimide that is an isomer of a polyimide is produced by adding a dehydrating agent such as N,N-dicyclohexylcarbodiimide or trifluoroacetic anhydride to the linear polyimide precursor solution and then by causing a reaction through stirring at 0 to 100°C, preferably 0 to 60°C. The isoimidization reaction can be performed by immersing the linear polyimide precursor film into the solution containing the dehydrating agent. After a film is formed using the polyisoimide varnish in the same procedure as that described above, the film is heat treated at 250 to 450°C, preferably at 270 to 400°C. Consequently, the polyisoimide can be easily converted into a polyimide. Additives such as an oxidation stabilizer, a filler, an adhesion promoter, a silane coupling agent, a photosensitizer, a photoinitiator, a sensitizer, end-cappers, and a cross-linker can be optionally added to the polyimide of the present invention and its precursor.

After the obtained polyimide varnish is cast on an insoluble polyimide film surface to form a film, a copper clad laminate can be made by placing copper foil on the film and then by thermal lamination under a pressure. Moreover, after a photoresist is applied to the copper foil and patterned by exposure, a flexible printed circuit (FPC) can be made by forming a circuit through etching the copper foil using a ferric chloride solution or the like.

To apply the polyimide of the present invention to heat-resistant adhesives in the pseudo two-layered FCCL, the glass transition temperature of the polyimide is preferably 270°C or more, more preferably 300°C or more. The elongation in a tensile test is preferably 10% or more, more preferably 20% or more. The polyimide preferably posesses high solubility in an aprotic organic solvent such as NMP or DMAc by 10% or more by mass, more preferably 20% or more by mass. The polyimide of the present invention preferably has higher thermoplasticity. When the laminate is made with the copper foil, the peel strength is preferably 0.8 kgf/cm or more, more preferably 1.0 kgf/cm or more, as an indication of thermoplasticity.

### <Applications>

The polyimide of the present invention has good processability, that is, solubility in an organic solvent and thermoplasticity together with high glass transition temperature and toughness. Therefore, the polyimide is significantly useful as a resin that is used for a heat-resistant adhesive in flexible printed circuit (FPC). The polyimide of the present invention is obviously useful as well for various electronic devices such as a different TAB substrate, a protection film of semiconductor devices, and an interlayer insulating film of integrated circuits.

### Examples

The present invention will now be described in detail with Examples. However, the present invention is not limited to Examples. The physical properties in Examples were measured by the following methods.

### <Infrared Absorption Spectrum>

The infrared absorption spectrum of a polyimide thin film was measured in transmission mode using a Fourier transform infrared spectrophotometer (FT/IR5300 or FT/IR350 available from JASCO Corporation).

### <Intrinsic Viscosity>

The intrinsic viscosities of 0.5% by mass of polyimides' solution (solvent: NMP) were measured at 30°C using an Ostwald viscometer. However, since the polyimide in Example 5 was insoluble in NMP, the intrinsic viscosity of the corresponding linear polyimide precursor was measured using DMAc and the result was described in Table 1. The intrinsic viscosities of other linear polyimide precursor were substantially the same as those of the corresponding polyimides.

### <Glass Transition Temperature: Tg>

The glass transition temperatures of a polyimide films were determined from loss peaks at a frequency of 0.1 Hz and at a heating rate of 5°C/min that are obtained through dynamic viscoelastic measurement using a thermomechanical analyzer (TMA4000) available from Bruker AXS K.K.

### <Linear Coefficient of Thermal Expansion: CTE>

The linear coefficient of thermal expansion of a polyimide film was measured as an average value between 100 to 200°C from the elongation of a specimen at load of 0.5 g per 1 µm film thickness at a heating rate of 5°C/min. The elongation was obtained through thermal mechanical analysis using a thermal mechanical analyzer (TMA4000) available from Bruker AXS K.K.

### <5% Weight Loss Temperatures: T_{d}⁵>

The temperature when the initial mass of a polyimide film was decreased by 5% at a heating rate of 10°C/min in a nitrogen atmosphere or in the air was measured using a thermogravimetric analyzer (TG-DTA2000) available from Bruker AXS K.K. Thermal stability increases as the value of 5% mass loss temperature increases.

### <Dielectric Constant>

Refractive indices in a direction parallel to a polyimide film (nᵢₙ) and in a direction perpendicular to the polyimide film (nₒᵤₜ) were measured using an Abbe refractometer (Abbe 4T: sodium lamp at a wavelength of 589 nm) available from ATAGO CO., LTD. On the basis of the average refractive index of a polyimide film [nₐᵥ = (2nᵢₙ + nₒᵤₜ)/3], the dielectric constant (ε_{cal}) of a polyimide film at 1 MHz was estimated on the basis of the following relation: ε_{cal} = 1.1 × nₐᵥ².

### <Water Absorption>

After a polyimide film (film thickness: 20 to 30 µm) that was vacuum dried at 50°C for 24 hours was immersed in water at 25°C for 24 hours, excess water was removed and water absorption (%) was obtained from mass increase.

### <Tensile Modulus, Tensile Strength, and Elongation at Breal>

A tensile test (stretching rate: 8 mm/min) was conducted for the polyimide film specimens (3 mm × 30 mm) on a mechanical testing machine (Tensilon UTM-2) available from Toyo Baldwin Co., Ltd. Elastic modulus (Young's modulus) was obtained from the initial gradient of the stress-strain curve. Elongation (%) was obtained from percentage of stretch when the film was broken. Higher elongation means higher toughness of a film.

### <Solubility Test>

The solubility at room temperature was tested by inserting 10 mg of polyimide power into 1 mL of solvents.

### <Peel Test: Peel Strength>

To evaluate the adhesion strength between copper foil and the polyimide of the present invention, a specimen in which a polyimide layer was directly formed on copper foil was prepared as follows. Polyimide varnish (solvent: NMP, 15 to 20% by mass) was applied to a matte surface of electrodeposited copper foil (F3-WS with a thickness of 18 µm available from FURUKAWA ELECTRIC CO., LTD.), dried at 80°C for three hours, and then annealed at 350°C under vacuum for two hours to obtain a specimen of a two-layer copper clad laminate.

To investigate whether the polyimide of the present invention can be used as a heat-resistant adhesive for a pseudo two-layer copper clad laminate, another type of specimen was prepared as follows. As described above, the polyimide varnish was applied to the electrodeposited copper foil (F2-WS with a thickness of 12 µm available from FURUKAWA ELECTRIC CO., LTD.), dried, and then vacuum dried at 200°C for one hour. Subsequently, a non-thermoplastic polyimide film (Apical NPI with a thickness of 25 µm available from KANEKA CORPORATION) was heat compressed onto the surface of the thermoplastic polyimide film at a pressure of 6.2 MPa at 360°C for 30 minutes to complete a specimen.

A 180° peel test was conducted on the specimens under the same conditions as those of the tensile test described above to measure peel strength. Table 3 shows the results.

### <Synthesis of 1,2,3,4-benzenetetracarboxylic acid>

Synthesis of 1,2,3,4-benzenetetracarboxylic acid was performed by oxidizing 1,2,3,4,5,6,7,8-octahydrophenanthrene through liquid phase oxidation using potassium permanganate or the like as an oxidizing agent (refer to Japanese Patent Application No. 2007-110118).

### <Synthesis of Mellophanic Dianhydride>

In accordance with a method described in Macromolecules, vol. 35, 8708 (2002), mellophanic dianhydride was synthesized by using the reaction of 1,2,3,4-benzenetetracarboxylic acid and an excessive amount of acetic anhydride. The analysis values of the obtained mellophanic dianhydride were, for example, as follows. Melting point: 196.5 to 198°C, Gas chromatography (GC) purity: 99.8%, Elemental Analysis; carbon: 54.8%, hydrogen: 0.98%, oxygen: 44.2%.

### Example 1 (Manufacturing of linear polyimide precursor, Imidization, and Evaluation of Polyimide Film Characteristics)

First, 3 mmol of 2,2-bis(4-(4-aminophenoxy)phenyl)propane (hereinafter referred to as BAPP) was inserted into a well-dried sealed reactor with a stirrer and then dissolved in 7.3 mL of NMP that was sufficiently dehydrated using molecular sieves 4A. Subsequently, 3 mmol of mellophanic dianhydride (hereinafter referred to as MPDA) powder was added to the solution. The admixture was stirred at room temperature for three hours to obtain a linear polyimide precursor solution that was transparent, uniform, and viscous.

The linear polyimide precursor solution did not cause precipitation and gelation even after being left to stand at room temperature or -20°C for one month, which meant the precursor solution had significantly high solution storage stability. The intrinsic viscosity of 0.5% by mass of the linear polyimide precursor in NMP was measured at 30°C using an Ostwald viscometer. The intrinsic viscosity was 1.57 dL/g.

After the linear polyimide precursor varnish was properly diluted, 10 mL of a cyclodehydration reagent (acetic anhydride/pyridine = 7/3 by volume) was dropped into the diluted varnish. The imidization was performed by stirring the diluted varnish at room temperature for 12 hours. The obtained polyimide varnish was dropped into a large amount of methanol to isolate a polyimide as powder. The obtained polyimide powder was vacuum dried at 80°C, and then dissolved in NMP (12% by mass) again so as to be in a varnish state. The varnish was applied to a glass substrate and dried at 80°C for two hours using hot air to obtain a polyimide film. The obtained polyimide film on the substrate was further dried under reduced pressure at 250°C for two hours to obtain a polyimide film having a thickness of 20 µm.

The polyimide film was not broken even when folded in half, which meant the polyimide film had flexibility. In a solubility test with polyimide powder, the polyimide showed high solubility in DMAc, N,N-dimethylformamide, γ-butyrolactone, dimethyl sulfoxide, chloroform, and the like in addition to NMP at room temperature. Table 1 shows the film properties of the polyimide.

According to the result of dynamic viscoelastic measurement, the glass transition temperature was 280°C. The storage elastic modulus was significantly decreased at a temperature equal to or higher than the glass transition temperature, which meant the polyimide had high thermoplasticity. In a tensile test, the Young's modulus was 1.92 GPa and the tensile strength was 110 MPa, both of which were ordinary values. In contrast, the elongation was 161.2%, which meant significantly high toughness. Regarding other film properties, the linear coefficient of thermal expansion was 53.6 ppm/K and the 5% weight loss temperatures were 490°C in a nitrogen and 457°C in the air. The dielectric constant estimated from the average refractive index was 3.12. The water absorption was a relatively low value of 0.93%. Thus, the polyimide achieved good thermo-and solution- processability, a high glass transition temperature higher than 270°C, high thermal stability, and significantly high film toughness. Fig. 1 shows an infrared absorption spectrum of the polyimide thin film (thickness: about 5 µm). Table 2 shows the result of the solubility test.

### Example 2

A linear polyimide precursor was manufactured and then imidized to form a polyimide film in accordance with the same method as that described in Example 1 except that 1,1,1,3,3,3-hexafluoro-2,2-bis(4-(4-aminophenoxy)phenyl)propane (hereinafter referred to as HFBAPP) was used as a diamine component instead of BAPP. Table 1 shows its film properties. The polyimide film had high glass transition temperature higher than 270°C, significantly low water absorption, high solubility in NMP, DMAc, and the like, high thermoplasticity, and satisfactory film toughness. Fig. 2 shows an infrared absorption spectrum of the polyimide thin film (thickness: about 5 µm).

### Example 3

A linear polyimide precursor was manufactured and then imidized to form a polyimide film in accordance with the same method as that described in Example 1 except that 3,4'-oxydianiline (hereinafter referred to as 3,4'-ODA) was used as a diamine component instead of BAPP. Table 1 shows its film properties. The polyimide film had high glass transition temperature higher than 300°C, high solubility in NMP, DMAc, and the like, high thermoplasticity, and satisfactory film toughness. Table 2 shows the result of the solubility test. Fig. 3 shows an infrared absorption spectrum of the polyimide thin film (thickness: about 5 µm).

### Example 4

A linear polyimide precursor was manufactured and then imidized to form a polyimide film in accordance with the same method as that described in Example 1 except that 2,2'-bis(trifluoromethyl)benzidine (hereinafter referred to as TFMB) was used as a diamine component instead of BAPP. Table 1 shows its film properties. The polyimide film had significantly high glass transition temperature, high solubility in NMP, DMAc, and the like, high thermoplasticity, and satisfactory film toughness. Fig. 4 shows an infrared absorption spectrum of the polyimide thin film (thickness: about 5 µm).

### Example 5

A linear polyimide precursor was manufactured and then imidized to form a polyimide film in accordance with the same method as that described in Example 1 except that 1,3-bis(4-aminophenoxy)benzene (hereinafter referred to as TPE-R) was used as a diamine component instead of BAPP. The obtained polyimide had sufficiently high glass transition temperature, high solubility in NMP, DMAc, and the like, high thermoplasticity, and satisfactory film toughness. Table 1 shows its film properties. Fig. 5 shows an infrared absorption spectrum of the polyimide thin film (thickness: about 5 µm).

### Example 6

A linear polyimide precursor was manufactured and then imidized to form a polyimide film in accordance with the same method as that described in Example 1 except that BAPP and 4,4'-ODA were used together as diamine components instead of BAPP used alone. The copolymerization composition (mole ratio) was BAPP:4,4'-ODA = 70:30. The obtained polyimide had sufficiently high glass transition temperature, high solubility in NMP, DMAc, and the like, high thermoplasticity, and satisfactory film toughness. Table 1 shows its film properties. Table 2 shows the result of the solubility test. Fig. 6 shows an infrared absorption spectrum of the polyimide thin film (thickness: about 5 µm).

### Example 7

A linear polyimide precursor was manufactured and then imidized to form a polyimide film in accordance with the same method as that described in Example 1 except that BAPP and 4,4'-ODA were used together as diamine components instead of BAPP used alone. The copolymerization composition (mole ratio) was BAPP:4,4'-ODA = 60:40. The obtained polyimide had sufficiently high glass transition temperature, high solubility in NMP, DMAc, and the like, high thermoplasticity, and satisfactory film toughness. Table 1 shows its film properties. Table 2 shows the result of the solubility test.

### Example 8

A linear polyimide precursor was manufactured and then imidized to form a polyimide film in accordance with the same method as that described in Example 1 except that BAPP and 4,4'-ODA were used together as diamine components instead of BAPP used alone. The copolymerization composition (mole ratio) was BAPP:4,4'-ODA = 55:45. The obtained polyimide had sufficiently high glass transition temperature, high solubility in NMP, DMAc, and the like, high thermoplasticity, and satisfactory film toughness. Table 1 shows its film properties.

### Example 9

A linear polyimide precursor was manufactured and then imidized to form a polyimide film in accordance with the same method as that described in Example 1 except that BAPP and 4,4'-ODA were used together as diamine components instead of BAPP used alone. The copolymerization composition (mole ratio) was BAPP:4,4'-ODA = 50:50. The obtained polyimide had sufficiently high glass transition temperature, high solubility in NMP, DMAc, and the like, high thermoplasticity, and satisfactory film toughness. Table 1 shows its film properties.

### Example 10

A linear polyimide precursor was manufactured and then imidized to form a polyimide film in accordance with the same method as that described in Example 1 except that BAPP and 4,4'-ODA were used together as diamine components instead of BAPP used alone. The copolymerization composition (mole ratio) was BAPP:4,4'-ODA = 80:20. The obtained polyimide had sufficiently high glass transition temperature, high solubility in NMP, DMAc, and the like, high thermoplasticity, and satisfactory film toughness. Table 1 shows its film properties.

### <Peel Test: Peel Strength>

Table 3 shows the result of the peel test. When a two-layer copper clad laminate was used as a specimen, the peel strength was close to or higher than 1.0 kgf/cm. Thus, sufficient adhesiveness between the polyimide of the present invention and the copper foil was confirmed. Furthermore, when a pseudo two-layer copper clad laminate was used as a specimen, a sufficient peel strength of 0.84 to 1.2 kgf/cm was also achieved without any adhesion promoters.

### Comparative Example 1

A linear polyimide precursor was polymerized in accordance with the method described in Example 1, using pyromellitic dianhydride (hereinafter referred to as PMDA) as a tetracarboxylic dianhydride component instead of mellophanic dianhydride (MPDA) and using BAPP as a diamine component. Although imidization was attempted by adding a cyclodehydration reagent into the obtained solution as in the method described in Example 1, the solution turned into a gel. Therefore, a polyimide film was formed by performing imidization through heating under the following conditions. The linear polyimide precursor solution was applied to a glass substrate, dried at 60°C for two hours, and then heat treated under vacuum at 350°C for two hours to obtain a polyimide film. Table 1 shows its film properties. The polyimide film had high glass transition temperature and high film toughness. However, the polyimide showed no solubility in any solvents in a solubility test, which meant it had no solution processability (Table 2). This is because mellophanic dianhydride (MPDA) was not used as a tetracarboxylic dianhydride component. Since the polyimide was completely insoluble in solvents as described above, the intrinsic viscosity in Table was obtained using the linear polyimide precursor instead of the polyimide.

### Comparative Example 2

A linear polyimide precursor was manufactured and then imidized to form a polyimide film in accordance with the same method as that described in Comparative Example 1 except that 3,4'-ODA was used as a diamine component instead of BAPP. Table 1 shows its film properties. In this polyimide film, clear glass transition temperature was not observed through dynamic viscoelastic measurement. Thus, thermoplasticity that is necessary for applying the polyimide to a heat-resistant adhesive was completely unsatisfactory. In addition, the polyimide showed no solubility in any solvents in a solubility test, which meant it had no solution processability (Table 2). This is because mellophanic dianhydride (MPDA) was not used as a tetracarboxylic dianhydride component. Since the polyimide was completely insoluble in solvents as described above, the intrinsic viscosity in Table was obtained using the linear polyimide precursor instead of the polyimide.

### Comparative Example 3

A linear polyimide precursor was polymerized and then imidized to form a polyimide film in accordance with the same method as that described in Comparative Example 1 except that BAPP and 4,4'-ODA were used together as diamine components instead of BAPP used alone. The copolymerization composition (mole ratio) was BAPP:4,4'-ODA = 70:30. Table 1 shows its film properties. The polyimide film had high glass transition temperature and high film toughness. However, the polyimide showed no solubility in any solvents in a solubility test, which meant it had no solution processability (Table 2). This is because mellophanic dianhydride was not used as a tetracarboxylic dianhydride component. Since the polyimide was completely insoluble in solvents as described above, the intrinsic viscosity in Table was obtained using the linear precursor of polyimide instead of the polyimide.

### Comparative Example 4

A linear polyimide precursor was manufactured and then imidized to form a polyimide film in accordance with the same method as that described in Comparative Example 1 except that BAPP and 4,4'-ODA were used together as diamine components instead of BAPP used alone. The copolymerization composition (mole ratio) was BAPP:4,4'-ODA = 60:40. Table 1 shows its film properties. The polyimide film had high glass transition temperature and high film toughness. However, the polyimide showed no solubility in any solvents in a solubility test, which meant it had no solution processability (Table 2). This is because mellophanic dianhydride (MPDA) was not used as a tetracarboxylic dianhydride component. Since the polyimide was completely insoluble in solvents as described above, the intrinsic viscosity in Table was obtained using the linear polyimide precursor instead of the polyimide.

**Table 1-1 Properties of Polyimide Film**

| | Acid dianhydride | Diamine | Intrinsic viscosity (dL/g) | Tg (°C) | CTE (ppm/K) |
|---|---|---|---|---|---|
| Example 1 | MPDA | BAPP | 1.57 | 280 | 53.6 |
| Example 2 | MPDA | HFBAPP | 0.61 | 272 | 56.7 |
| Example 3 | MPDA | 3,4'-ODA | 1.64 | 315 | 46.3 |
| Example 4 | MPDA | TFMB | 1.02 | 400 | 35.7 |
| Example 5 | MPDA | TPE-R | 1.14 | 272 | 56.3 |
| Example 6 | MPDA | BAPP:4,4'-ODA (mole ratio = 70:30) | 1.18 | 289 | 49.5 |
| Example 7 | MPDA | BAPP:4,4'-ODA (mole ratio = 60:40) | 0.84 | 294 | 54.1 |
| Example 8 | MPDA | BAPP:4,4'-ODA (mole ratio = 55:45) | 1.31 | 298 | 48.5 |
| Example 9 | MPDA | BAPP:4,4'-ODA (mole ratio = 50:50) | 1.16 | 304 | 46.9 |
| Example 10 | MPDA | BAPP:4,4'-ODA (mole ratio = 80:20) | - | 294 | 60.0 |
| Comparative Example 1 | PMDA | BAPP | 2.30 | 287 | 56.7 |
| Comparative Example 2 | PMDA | 3,4'-ODA | 1.00 | undetected | 43.5 |
| Comparative Example 3 | PMDA | BAPP:4,4'-ODA (mole ratio = 70:30) | 1.46 | 316 | 57.4 |
| Comparative Example 4 | PMDA | BAPP:4,4'-ODA (mole ratio = 60:40) | 1.17 | 321 | 56.9 |

| | | | | | |
|---|---|---|---|---|---|
| * "-" in Table means that measurement is not performed. | | | | | |

**Table 1-2 Properties of Polyimide Film**

| | T_{d}⁵(N₂) (°C) | T_{d}⁵(air) (°C) | ε_{cal} | Water absorption | Elongation (%) | Young's modulus |
|---|---|---|---|---|---|---|
| Example 1 | 490 | 457 | 3.12 | 0.93 | 161.2 | 1.92 |
| Example 2 | 512 | 490 | 2.86 | 0.44 | 21.2 | 2.24 |
| Example 3 | 507 | 485 | 3.15 | 2.56 | 9.3 | 2.15 |
| Example 4 | 551 | 537 | 2.81 | 1.11 | 14.9 | 2.56 |
| Example 5 | 467 | 444 | 3.11 | 0.41 | 4.9 | 2.05 |
| Example 6 | 488 | 453 | 3.07 | 0.41 | 100.9 | 2.08 |
| Example 7 | 497 | 457 | 3.06 | 0.44 | 79.8 | 2.01 |
| Example 8 | 483 | 443 | 3.11 | - | - | - |
| Example 9 | 490 | 439 | 3.12 | - | 17.3 | 1.65 |
| Example 10 | 496 | 473 | - | 0.66 | 112.6 | 1.91 |
| Comparative Example 1 | 500 | 451 | 3.07 | - | 169.0 | 2.18 |
| Comparative Example 2 | 556 | 531 | 2.82 | - | - | - |
| Comparative Example 3 | 516 | 510 | - | 1.15 | 149.1 | 1.88 |
| Comparative Example 4 | 522 | 509 | - | 1.18 | 175.1 | 1.74 |

| | | | | | | |
|---|---|---|---|---|---|---|
| * "-" in Table means that measurement is not performed. | | | | | | |

**Table 2**

| | NMP | DMAc | DMF | GBL | DMSO | Chloroform | THF |
|---|---|---|---|---|---|---|---|
| Example 1 | ++ | ++ | ++ | ++ | ++ | ++ | ± |
| Example 3 | ++ | ++ | ± | ± | ++ | - | - |
| Example 6 | ++ | ++ | ++ | ++ | ++ | ± | - |
| Example 7 | ++ | ++ | ++ | ++ | ++ | ± | - |
| Comparative Example 1 | - | - | - | - | - | - | - |
| Comparative Example 2 | - | - | - | - | - | - | - |
| Comparative Example 3 | - | - | - | - | - | - | - |
| Comparative Example 4 | - | - | - | - | - | - | - |

| | | | | | | | |
|---|---|---|---|---|---|---|---|
| ++: quickly dissolved at room temperature, +: dissolved by heating, ±: partly dissolved by heating, -: not dissolved DMF: N,N-dimethylformamide GBL: γ-butyrolactone DMSO: dimethyl sulfoxide THF: tetrahydrofuran | | | | | | | |

Table 2 shows the results of only representative tested Examples.

**Table 3**

| Type of specimen | Polyimide | Polyimide raw materials | | Peel strength (kgf/cm) |
|---|---|---|---|---|
| | | Tetracarboxylic dianhydride | Diamine | |
| Two-layer copper clad laminate | Example 1 | MPDA | BAPP | 1.00 |
| | Example 2 | MPDA | HFBAPP | 0.93 |
| | Example 3 | MPDA | 3,4'-ODA | 1.07 |
| | Example 6 | MPDA | BAPP:4,4'-ODA (mole ratio = 70:30) | 0.93 |
| | Example 10 | MPDA | BAPP:4,4'-ODA (mole ratio = 80:20) | 0.87 |
| Pseudo two-layer copper clad laminate | Example 1 | MPDA | BAPP | 0.84 |
| | Example 3 | MPDA | 3,4'-ODA | 1.20 |
| | Example 6 | MPDA | BAPP:4,4'-ODA (mole ratio = 70:30) | 0.87 |
| | Example 10 | MPDA | BAPP:4,4'-ODA (mole ratio = 80:20) | 0.84 |

Table 3 shows the results of only representative tested Examples.

### Industrial Applicability

The linear polyimide precursor and the polyimide of the present invention has good solubility and thermoplasticity together with high glass transition temperature and toughness. Therefore, they are significantly useful, for example, as a resin used for a next-generation flexible printed circuit (FPC) adhesive.

## Claims

1. A linear polyimide precursor comprising a repeating unit represented by at least one formula selected from the group consisting of General Formula (1) and General Formula (2), the linear polyimide precursor having an intrinsic viscosity of 0.5 dL/g or more, 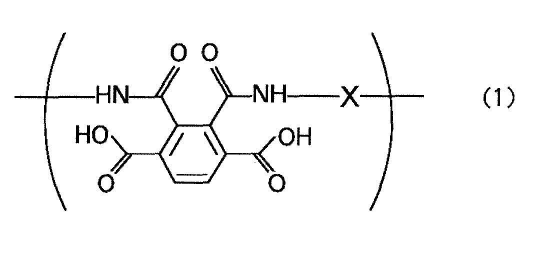 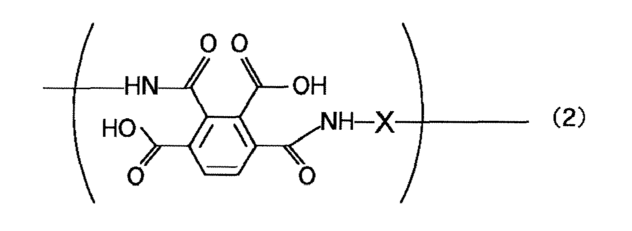 (wherein, in General Formulas (1) and (2), X is a divalent aromatic group or a divalent aliphatic group excluding residues of 1,4-bis(4-aminophenoxy)benzene and bis(4-amino-3-methylphenyl)methane.)

2. The linear polyimide precursor according to Claim 1, wherein the X is a divalent group containing a group represented by General Formula (3); and assuming that Y is a mole fraction of the group represented by General Formula (3) relative to the X, the Y is 0.1 to 1.0: 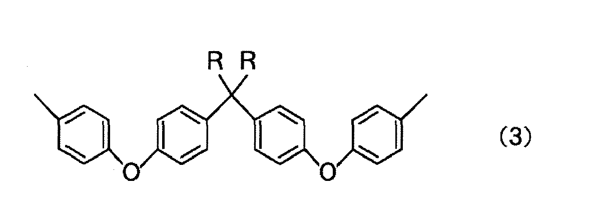 (wherein, in General Formula (3), two Rs are both methyl groups or both trifluoromethyl groups, or one of the two Rs is a methyl group and the other is a trifluoromethyl group.)

3. A method for manufacturing the linear polyimide precursor according to Claim 1, wherein at least one kind of monomer selected from mellophanic dianhydride and its derivatives and a diamine monomer excluding 1,4-bis(4-aminophenoxy)benzene and bis(4-amino-3-methylphenyl)methane are polymerized in an organic solvent in which the total monomer concentration is 10 to 50% by mass until a solution viscosity reaches its maximum.

4. A polyimide comprising a repeating unit represented by General Formula (4), the polyimide having an intrinsic viscosity of 0.5 dL/g or more, 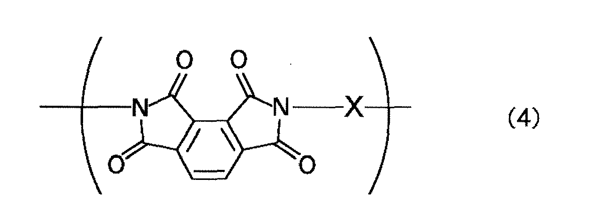 (wherein, in General Formula (4), X is a divalent aromatic group or a divalent aliphatic group excluding residues of 1,4-bis(4-aminophenoxy)benzene and bis(4-amino-3-methylphenyl)methane.)

5. The polyimide according to Claim 4, wherein the X is a divalent group containing a group represented by General Formula (3); and assuming that Z is a mole fraction of the group represented by General Formula (3) relative to the X, the Z is 0.1 to 1.0: 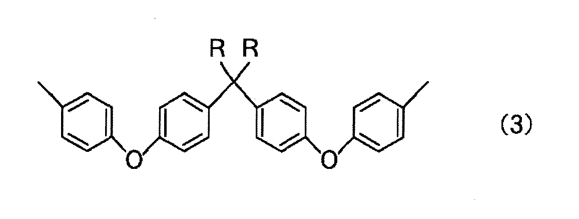 (wherein, in General Formula (3), two Rs are both methyl groups or both trifluoromethyl groups, or one of the two Rs is a methyl group and the other is a trifluoromethyl group.)

6. The polyimide according to Claim 4 having a glass transition temperature of 270°C or higher, a solubility in an aprotic organic solvent of 10% or more by mass, a peel strength of 0.8 kgf/cm or more when a laminate is made together with copper foil, and film toughness with an elongation of 10% or more.

7. A method for manufacturing the polyimide according to Claim 4, wherein a solution of the linear polyimide precursor according to Claim 1 is processed using at least one selected from the group consisting of heat and a cyclodehydration reagent.

8. A method for manufacturing the polyimide according to Claim 4, wherein at least one kind of monomer selected from mellophanic dianhydride and its derivatives is allowed to react with a diamine monomer excluding 1,4-bis(4-aminophenoxy)benzene and bis(4-amino-3-methylphenyl)methane in a solvent through a one-pot polycondensation reaction without isolating the corresponding reactive intermediate.

9. A heat-resistant adhesive comprising the polyimide according to any one of Claims 4 to 6.

10. A copper clad laminate comprising the heat-resistant adhesive according to Claim 9, a non-thermoplastic polyimide film, and copper foil.

11. A flexible printed circuit comprising the copper clad laminate according to Claim 10.

12. A flexible printed circuit obtained by etching a copper layer of the copper clad laminate according to Claim 10.

13. A linear polyimide precursor comprising a repeating unit represented by General Formula (1) or General Formula (2), the linear polyimide precursor having an intrinsic viscosity of 0.5 dL/g or more, 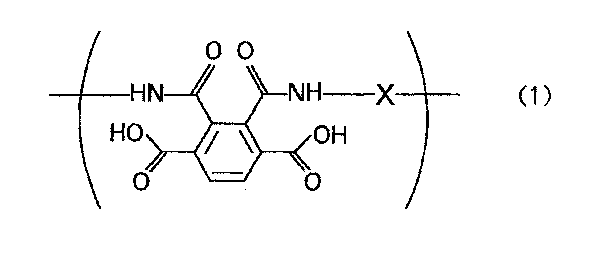 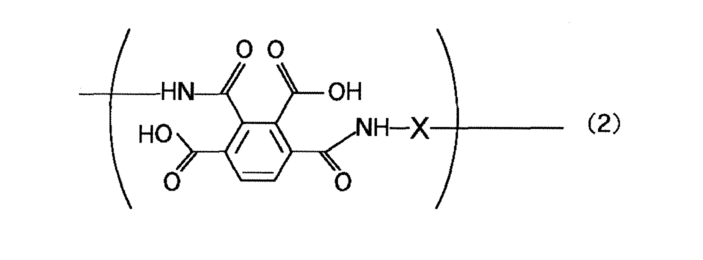 (wherein, in General Formulas (1) and (2), X is a divalent aromatic group or a divalent aliphatic group excluding residues of 1,4-bis(4-aminophenoxy)benzene and bis(4-amino-3-methylphenyl)methane.)
